Europäisches Patentamt

European Patent Office

Office européen des brevets

(11) Numéro de publication: **0 161 135**
**A1**

(12) # DEMANDE DE BREVET EUROPEEN

(21) Numéro de dépôt: **85400569.1**

(22) Date de dépôt: **22.03.85**

(51) Int. Cl.⁴: **H 03 B 5/36**

(30) Priorité: **27.03.84 FR 8404747**

(43) Date de publication de la demande:
**13.11.85 Bulletin 85/46**

(84) Etats contractants désignés:
**AT BE CH DE GB IT LI LU NL SE**

(71) Demandeur: **COMPAGNIE D'ELECTRONIQUE ET DE PIEZO-ELECTRICITE - C.E.P.E.**
**44, rue de la Glacière**
**F-95100 Argenteuil(FR)**

(72) Inventeur: **Renoult, Patrick**
**THOMSON-CSF SCPI 173, bld Haussmann**
**F-75379 Paris Cedex 08(FR)**

(72) Inventeur: **Marotel, Gérard**
**THOMSON-CSF SCPI 173, bld Haussmann**
**F-75379 Paris Cedex 08(FR)**

(74) Mandataire: **Ruellan-Lemonnier, Brigitte et al,**
**THOMSON-CSF SCPI 173, boulevard Haussmann**
**F-75379 Paris Cedex 08(FR)**

(54) **Oscillateur piezo-électrique fonctionnant en mode apériodique.**

(57) L'invention concerne un oscillateur piézo-électrique fonctionnant en mode apériodique du type CLAPP.

Il comprend un résonateur piézo-électrique $Q_1$ présentant une fréquence de résonance de mode C à laquelle l'oscillateur doit fonctionner. Il est branché entre la base d'un transistor $T_1$ et la masse. Entre la base du transistor et la masse est branché également un pont diviseur capacitif $C_1$, $C_2$ dont le point dit point milieu est replié à l'émetteur du transistor. Entre l'émetteur du transistor et la masse sont disposés un quartz $Q_2$ et une self $L_1$ découplée par un condensateur $C_3$. La self $L_1$ et le condensateur $C_2$ forment un filtre passe-haut affaiblissant les fréquences inférieures à ladite fréquence de résonance et le résonateur piézo-électrique $Q_2$ est accordé sur le mode B voisin du mode C précité de manière a éliminer le mode B indésirable.

FIG_1

# OSCILLATEUR PIEZO-ELECTRIQUE FONCTIONNANT EN MODE APERIODIQUE

La présente invention a pour objet un oscillateur piézo-électrique fonctionnant en mode apériodique, du type Clapp.

On connaît de la demande de brevet français N° 81.04917 déposée le 3 Mars 1981 par la Demanderesse, un oscillateur piézo-électrique fonctionnant en mode apériodique, du type Clapp et comprenant un résonateur piézo-électrique présentant une fréquence de résonance à laquelle l'oscillateur doit fonctionner, ledit résonateur étant branché entre la base d'un transistor et la masse, ainsi qu'un pont diviseur capacitif présentant un point dit point milieu, et l'émetteur du transistor étant chargé par une résistance de charge.

L'invention a pour objet un oscillateur du type précité présentant une meilleure sélectivité assurée par un filtrage sélectif.

Selon un premier mode de réalisation, le filtrage est passe-haut et coupe-bande, et l'oscillateur comporte, en parallèle entre ledit point milieu et la masse, d'une part une self, celle-ci formant avec le condensateur du pont capacitif disposé entre le point milieu et la masse un filtre passe-haut affaiblissant les fréquences inférieures à ladite fréquence de résonance, et d'autre part un résonateur piézo-électrique accordé sur un second mode de fréquence supérieure à ladite fréquence de résonance, de manière à éliminer ledit mode.

Ledit mode de fréquence supérieure à ladite fréquence de résonance peut être un partiel de rang supérieur dans le cas d'une coupe à simple rotation, ou un mode du même partiel dans le cas d'une coupe à double ou triple rotation, par exemple pour une coupe SC, le mode B voisin du mode C qui est utilisé comme fréquence de résonance.

Selon un second mode de réalisation, le filtrage est coupe-bande, et l'oscillateur est caractérisé en ce qu'il comporte une

2

pluralité de résonateurs piézo-électrique accordés sur les modes non désirés et branchés en parallèle entre ledit point milieu et la masse.

L'invention sera mieux comprise à la lecture de la description qui va suivre, donnée à titre d'exemple non limitatif en liaison avec les figures qui représentent :

- la figure 1, le premier mode de réalisation de l'invention dans le cas d'une coupe SC (double rotation) ;

- la figure 2, le second mode de réalisation de l'invention ; et,

- la figure 3, la réponse en boucle ouverte de l'oscillateur en fonction de la fréquence F, correspondant au cas de la figure 1.

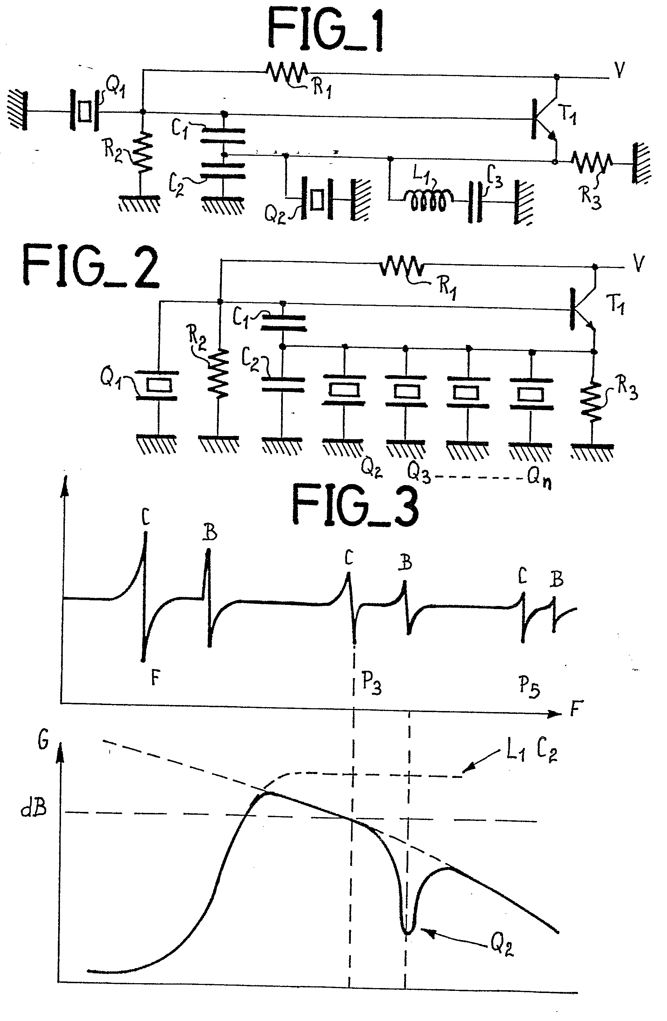

Selon la figure 1, l'oscillateur comporte un transistor $T_1$ dont le collecteur est polarisé par une tension V et la base par division de cette tension par un pont diviseur $R_1$ et $R_2$. Entre la base et la masse est disposé un pont diviseur capacitif $C_1$, $C_2$ dont le point dit point milieu est relié à l'émetteur du transistor $T_1$. L'émetteur est chargé par une résistance $R_3$ disposée entre celui-ci et la masse. Un quartz $Q_1$ en coupe SC présentant une fréquence de résonance (partiel 3) de mode C qui est celle à laquelle l'oscillateur doit fonctionner est branché entre la base du transistor et la masse. La fonction de filtrage passe-haut est réalisée par une self $L_1$ disposée entre ledit point milieu et la masse. Un condensateur $C_3$ découple la self $L_1$ du côté de la masse. Les paramètres de la fonction passe-haut sont déterminés par la valeur de la self $L_1$ et du condensateur $C_2$. Particulièrement à la figure 3, l'oscillateur fonctionne sur le mode C du partiel 3 en éliminant le mode B. $L_1$ et $C_2$ sont choisis de telle manière que la courbe de gain de l'amplificateur chute en-dessous de la fréquence du partiel 3 de manière à éliminer le fondamental F comportant un mode B et un mode C. Le partiel 5 est éliminé par la chute naturelle du gain de l'amplificateur $T_1$. Le mode B du partiel 3 est éliminé par un résonateur $Q_2$ qui est branché entre le point milieu et la masse et qui présente un mode a la fréquence du mode B du partiel 3 du résonateur $Q_1$. Cette fréquence correspond à un facteur de qualité Q très inférieur à celui du mode

3

B du partiel 3 du résonateur $Q_1$ dans un rapport de préférence compris entre 30 et 1000 fois.

Dans ces conditions, la condition de gain de Berkhausen de l'oscillateur est satisfaite pour le mode C du partiel 3. On remarquera qu'en dessous de la fréquence du mode C du partiel 3 du résonateur $Q_1$, le gain de l'amplificateur augmente quelque peu, mais cela ne présente pas d'inconvénients pratiques en raison de l'absence dans cette zone d'une fréquence de résonance sur lequel l'oscillateur serait susceptible de s'accrocher.

Selon la figure 2, la fonction passe-haut réalisée par la self $L_1$ est remplacée par une pluralité de fonctions coupe-bande ponctuelles $Q_3$ etc jusqu'à $Q_n$ a partir de résonateurs présentant des fréquences correspondant aux modes indésirables du quartz $Q_1$ de manière à remplir la fonction précédemment remplie par la self $L_1$. Le facteur de qualité des fréquences choisies des résonateurs $Q_2$ à $Q_n$ est de l'ordre de 30 à 1000 fois plus faible de ceux des modes correspondants à éliminer. Ce mode de réalisation permet d'éliminer de manière plus efficace les partiels indésirables qui pourraient présenter des facteurs de qualité élevés et par conséquent des pics correspondant à des pertes d'insertion faibles.

4

# REVENDICATIONS

1. Oscillateur piézo-électrique fonctionnant en mode apériodique, du type Clapp, et comprenant un premier résonateur piézo-électrique (Q1) présentant une fréquence de résonance à laquelle l'oscillateur doit fonctionner et qui est branché entre la base d'un transistor et la masse, ainsi qu'un pont diviseur capacitif ($C_1$, $C_2$) présentant un point dit point milieu, et l'émetteur du transistor étant chargé par une résistance de charge, caractérisé en ce qu'il comporte, en parallèle entre ledit point milieu et la masse, d'une part une self ($L_1$), celle-ci formant avec le condensateur ($C_2$) du pont capacitif disposé entre le point milieu et la masse, un filtre passe-haut affaiblissant les fréquences inférieures à ladite fréquence de résonance, et d'autre part un second résonateur piézo-électrique ($Q_2$) accordé sur un mode de fréquence supérieure à ladite fréquence de résonance de manière à éliminer ledit mode.

2. Oscillateur selon la révendication 1, caractérisé en ce que le premier résonateur est un quartz ($Q_1$) en coupe SC, en ce que ladite fréquence de résonance est le mode C du partiel 3, et ledit mode à éliminer, le mode B du partiel 3.

3. Oscillateur piézo-électrique fonctionnant en mode apériodique, du type Clapp, et comprenant un premier résonateur piézo-électrique ($Q_1$) présentant une fréquence de résonance a laquelle l'oscillateur doit fonctionner et qui est branché entre la base d'un transistor ($T_1$) et la masse, ainsi qu'un pont diviseur capacitif ($C_1$, $C_2$) présentant un point dit point milieu, et l'émetteur du transistor étant chargé par une résistance de charge ($R_3$) caractérisé en ce qu'il comporte une pluralité de résonateurs piézo-électriques ($Q_2 ... Q_n$) accordés sur les modes non désirés dudit premier résonateur ($Q_1$) et branchés en parallèle entre ledit point milieu et la masse.

4. Oscillateur selon la revendication 3, caractérisé en ce que

le premier résonateur $(Q_1)$ est un quartz en coupe SC, en ce que ladite fréquence de résonance est le mode C du partiel 3.

0161135

1/1

FIG_1

FIG_2

FIG_3

Office européen
des brevets

**RAPPORT DE RECHERCHE EUROPEENNE**

**0161135**
Numéro de la demande

EP 85 40 0569

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | SIEMENS-ZEITSCHRIFT, vol. 49, no. 5, 1975, pages 328-332, Erlangen, DE; H.-J. FÖRSTER: "Temperaturkompensierte Quarzoszillatoren für den Frequenzbereich 2 bis 60 MHz" * Figure 3; page 329, colonne de droite, ligne 5 - page 330, colonne de gauche, ligne 11 * | 1 | H 03 B 5/36 |
| | --- | | |
| A,D | FR-A-2 501 435 (CEPE) | 1 | |
| | ----- | | |
| | | | DOMAINES TECHNIQUES RECHERCHES (Int. Cl.4) |
| | | | H 03 B |

Le présent rapport de recherche a été établi pour toutes les revendications

| Lieu de la recherche | Date d'achèvement de la recherche | Examinateur |
|---|---|---|
| LA HAYE | 01-07-1985 | GYSEN L.A.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

  & : membre de la même famille, document correspondant

OEB Form 1503. 03.82